# EUROPÄISCHE PATENTSCHRIFT

(11) **EP 1 648 744 B1**
(45) Veröffentlichungstag und Bekanntmachung des Hinweises auf die Patenterteilung: **02.01.2008**
(21) Anmeldenummer: 04766343.0
(22) Anmeldetag: 28.07.2004
(51) Int. Cl.: B60R 16/02, H05K 1/02

(54) **ELEKTRONIKEINHEIT SOWIE VERFAHREN ZUR HERSTELLUNG EINER ELEKTRONIKEINHEIT**
ELECTRONIC UNIT AND METHOD FOR MANUFACTURING AN ELECTRONIC UNIT
BLOC ELECTRONIQUE ET PROCEDE DE FABRICATION D'UN BLOC ELECTRONIQUE

(30) Priorität: 01.08.2003 DE 10335338
(43) Veröffentlichungstag der Anmeldung: 26.04.2006
(73) Patentinhaber: Siemens VDO Automotive AG, 93055 Regensburg (DE)
(72) Erfinder: BRANDT, Jens, 98559 Oberhof (DE); KERNER, Nikolaus, 93173 Wenzenbach (DE)
(86) Internationale Anmeldenummer: PCT/EP2004/051634
(87) Internationale Veröffentlichungsnummer: WO 2005/012042

(56) Entgegenhaltungen:
- EP-A- 0 540 071
- DE-A- 19 541 925
- US-A- 5 079 672
- US-A- 5 099 396
- US-A1- 2002 112 870

## Beschreibung

Die vorliegende Erfindung betrifft eine Elektronikeinheit, insbesondere ein Steuergerät für ein Kraftfahrzeug, umfassend wenigstens eine mit elektronischen Komponenten bestückte Leiterplatte und ein die Leiterplatte umschließendes Gehäuse. Ferner betrifft die Erfindung ein Verfahren zur Herstellung sowie eine Verwendung einer derartigen Elektronikeinheit.

Aus dem Bereich der Kraftfahrzeugelektronik sind Steuergeräte zur Steuerung von elektrischen und elektronischen Fahrzeugkomponenten (z. B. Motorsteuergeräte) wohlbekannt, bei welchen zu Zwecken einer erhöhten Temperaturbeständigkeit die Schaltungsplatte (Schaltungsträger) mittels Dickschichttechnik oder Laminattechnik hergestellt ist.

Aus der US 5099396 A ist ein Elektronikeinheit nach dem Oberbegriff des Anspruchs 1 bekannt.

Bei der Dickschichttechnik wird beispielsweise ein relativ dickes Keramiksubstrat mit ebenfalls relativ dicken aufgebrannten Leiterbahnen vorgesehen. Dies hat deutliche Kostennachteile, da die Fertigung einer solchen Leiterplatte wesentlich teurer ist als die Fertigung einer einfachen Leiterplatte (z. B. mit einem dünnen Epoxid-Substrat).

Bei der Laminattechnik wird beispielsweise eine herkömmliche Leiterplatte durch Anwendung eines hohen Drucks und einer hohen Temperatur mit einer Metalllage zu einem Verbund zusammengefügt. Nachteilig ist hierbei, dass die in Laminattechnik hergestellte Leiterplatte lediglich einseitig mit elektronischen Komponenten bestückt werden kann, so dass bei vorgegebener elektronischer Schaltungsanordnung der Flächenbedarf im Vergleich zu herkömmlichen, jedoch zweiseitig bestückten Leiterplatten erhöht ist. Eine Vermeidung des erhöhten Flächenbedarfs beispielsweise durch Anordnung von zwei oder mehreren Leiterplatten übereinander ist oftmals nicht zufriedenstellend, da in diesem Fall der Bauraum sowie der Montageaufwand erhöht ist.

Ganz allgemein ist es in vielen Anwendungsfällen von Bedeutung, eine effiziente Wärmeabfuhr von den elektronischen Komponenten zum Gehäuse zu realisieren, insbesondere wenn in der Elektronikeinheit z. B. aktive Halbleiterleistungsbauelemente zum Einsatz kommen und/oder die Elektronikeinheit in einer Umgebung mit vergleichsweise hoher Umgebungstemperatur eingesetzt werden soll. Dies ist beispielsweise bei Steuergeräten für Kraftfahrzeuge der Fall, die in einem Kraftfahrzeug nahe oder unmittelbar an einer Brennkraftmaschine angeordnet werden, um z. B. die Kabelbaumkonfiguration des Fahrzeugs zu vereinfachen oder um eine elektronische Prüfung des Motors zusammen mit dem dazugehörigen Steuergerät in einfacher Weise zu ermöglichen. Für die bekannten motornah verbauten Steuergeräte wird üblicherweise die oben erwähnte Dickschichttechnik oder Laminattechnik verwendet.

Es ist eine Aufgabe der Erfindung, eine Elektronikeinheit der eingangs erwähnten Art hinsichtlich der Wärmeabfuhreigenschaften sowie hinsichtlich der Herstellungskosten zu verbessern.

Diese Aufgabe wird gelöst mit einer Elektronikeinheit nach Anspruch 1 und einem Verfahren zur Herstellung einer Elektronikeinheit nach Anspruch 11. Die abhängigen Ansprüche betreffen vorteilhafte Weiterbildungen der Erfindung.

Die erfindungsgemäße Elektronikeinheit besitzt wenigstens einen Leiterplattenabschnitt, der in einem Abstand von dem Gehäuse angeordnet ist und zweiseitig mit elektronischen Komponenten bestückt ist. Dieser oder diese Leiterplattenabschnitte werden im Folgenden als "erste(r) Leiterplattenabschnitt(e)" bezeichnet. Ferner besitzt die Leiterplatte wenigstens einen Leiterplattenabschnitt, der über eine wärmeleitende Klebstoffschicht mit dem Gehäuse verbunden ist. Dieser oder diese Leiterplattenabschnitte werden im Folgenden als "zweite(r) Leiterplattenabschnitt(e)" bezeichnet. Bei einem mehrteiligen Gehäuse kann diese Verklebung an dem oder den zweiten Leiterplattenabschnitten zu irgendeinem der Gehäuseteile erfolgen. Durch die partiell doppelseitige Bestückung (in dem wenigstens einen ersten Leiterplattenabschnitt) ergibt sich ein vergleichsweise geringer Flächenbedarf, insbesondere wenn der Anteil des oder der ersten Leiterplattenabschnitte an der Gesamtleiterplattenfläche wenigstens 30% beträgt. Darüber hinaus wirkt der zweite Leiterplattenäbschnitt vorteilhaft als mechanische und gleichzeitig thermische "Schnittstelle" zum Gehäuse, welches in dieser Hinsicht als mechanische Basis sowie Wärmesenke zu betrachten ist. Diese Schnittstelle von doppeltem Nutzen ist hierbei durch die Verbindung über eine Klebstoffschicht sehr zuverlässig, effizient, fertigungstechnisch günstig und bauraumsparend ausgebildet.

Nachfolgend wird der Einfachheit halber auch lediglich von dem ersten Leiterplattenabschnitt bzw. zweiten Leiterplattenabschnitt gesprochen, wenngleich jeweils mehrere solcher Abschnitte vorgesehen sein können. Die für einen solchen Leiterplattenabschnitt gegebenen Erläuterungen können dann ohne weiteres auf einen, mehrere oder alle der jeweiligen Mehrzahl von Leiterplattenabschnitten bezogen werden.

Die mit der Klebstoffschicht versehene Seite des zweiten Leiterplattenabschnitts ist bevorzugt mit einer Metallfläche (ausgedehnte Leiterbahn) versehen, um an dieser Stelle eine horizontale Wärmespreizung und gleichzeitig eine gute thermische Anbindung an die angrenzende Klebstoffschicht zu erzielen. Die der Klebstoffschicht entgegengesetzte Seite eines zweiten Leiterplattenabschnitts eignet sich gut für eine Bestückung mit elektronischen Komponenten, die besonders viel Wärme produzieren, da diese Wärme über die nahe darunter befindliche Klebstoffschicht mit geringem Wärmeübergangswiderstand weitergeleitet werden kann, insbesondere über an dieser Stelle angeordnete wärmeleitend metallisierte Durchgangsöffnungen ("vias").

Bevorzugt wird der Klebstoff als Flüssigklebstoff aufgebracht und dann ausgehärtet. Die Aushärtung des Klebstoffs kann in einfacher Weise thermisch vorgesehen sein. Für eine gute Wärmeableitungseffizienz ist die Verwendung eines Klebstoffs mit einer Wärmeleitfähigkeit von mindestens 0,5 W/mK, insbesondere mindestens 1 W/mK bevorzugt.

Die Klebstoffschichtverbindung zwischen der Leiterplatte und dem Gehäuse macht die bei herkömmlichen Elektronikeinheiten zur Befestigung üblicherweise vorgesehene Verschraubung entbehrlich. Falls die Elektronikeinheit mit einer Mehrzahl von parallel zueinander gestapelten Leiterplatten vorgesehen ist, so können die weiteren Leiterplatten beispielsweise unter Verwendung von geeigneten Abstandhaltern ebenfalls durch eine Verklebung und/oder eine herkömmliche Verschraubung im Inneren des Gehäuses befestigt werden.

In einer Ausführungsform umfasst das Gehäuse einen Gehäuseboden und einen damit verbundenen Gehäusedeckel. Dies besitzt den Vorteil, dass die Fertigung der Elektronikeinheit in einfacher Weise dadurch erfolgen kann, dass die bereits bestückte Leiterplatte zunächst in eines dieser Gehäuseteile eingeklebt wird und das Gehäuse dann durch Verbindung zwischen Gehäuseboden und Gehäusedeckel geschlossen wird. Für eine gute Wärmeableitung durch das Gehäuse hindurch ist es von Vorteil, wenn das Gehäuse insgesamt oder wenigstens der über die Klebstoffschicht mit der Leiterplatte thermisch verbundene Gehäuseteil aus einem gut wärmeleitenden Material gebildet ist, beispielsweise aus Metall (z. B. Aluminiumlegierung).

In einer bevorzugten Ausführungsform weist der Gehäuseboden im Querschnitt betrachtet Einbuchtungen zur Bereitstellung von Gehäuseinnenseitenabschnitten auf, die zur Verbindung mit dem wenigstens einen zweiten Leiterplattenabschnitt über die Klebstoffschicht verwendet sind.

Eine hinsichtlich der Fertigung einfache Verbindung zwischen Gehäuseboden und Gehäusedeckel kann beispielsweise durch eine geklebte Nut-und-Vorsprung-Verbindung realisiert sein. Hierfür kann insbesondere der ohnehin für die Verbindung zwischen Leiterplatte und Gehäuse benötigte Klebstoff verwendet werden. Einen guten Schutz des Gehäuseinnenraums vor einer Verschmutzung bietet eine Gestaltung, bei welcher ein an einem Gehäuseteil (Boden oder Deckel) ringförmig geschlossen am Rand umlaufender Vorsprung in eine am anderen Gehäuseteil korrespondierend angeordnete Nut eingreift.

Insbesondere für eine niedrige Bauhöhe der Elektronikeinheit ist es zur Bereitstellung einer elektrischen Anschlussmöglichkeit günstig, in dem Gehäusedeckel wenigstens einen Steckverbinder zum elektrischen zu integrieren. Hierbei können Anschlusspins des Steckverbinders geradlinig zu der dem Gehäusedeckel benachbarten Leiterplatte verlaufen und unmittelbar an dieser Leiterplatte kontaktiert sein. Insbesondere bei diesem geradlinigen Anschlusspinverlauf kann die Kontaktierung in einfacher Weise als Einpresskontaktierung vorgesehen sein und beispielsweise beim Schließen des Gehäuses durch Aufsetzen des mit dem oder den Steckverbindern versehenen Gehäusedeckels auf den Gehäuseboden.

Die konkrete Anordnung des oder der zweiten Leiterplattenabschnitte (in der Leiterplattenebene betrachtet) spielt eine Rolle hinsichtlich der Befestigung sowie der thermischen Ableitungseigenschaften. In diesem Zusammenhang hat es sich als günstig herausgestellt, wenn wenigstens zwei zweite Leiterplattenabschnitte vorgesehen sind, deren minimaler gegenseitiger Abstand größer als 40% einer maximalen Leiterplattenausdehnung ist. Dies wirkt vor allem vorteilhaft für eine stabile Lagerung der an den zweiten Leiterplattenabschnitten gehaltenen Leiterplatte. Unabhängig davon ist es günstig, wenn an einem Leiterplattenrand wenigstens einer der zweiten Leiterplattenabschnitte angeordnet ist. Schließlich ist es in dieser Hinsicht auch günstig, wenn wenigstens einer der zweiten Leiterplattenabschnitte entlang eines Großteils eines Leiterplattenrands verläuft, insbesondere ringförmig geschlossen entlang eines Leiterplattenrands verläuft. Eine solche ringförmige Anbindung der Leiterplatte an das Gehäuse hält die Leiterplatte besonders stabil und führt im Betrieb der Elektronikeinheit zu einer besonders gleichmäßigen Wärmeabfuhr.

Sofern die der Klebstoffschicht entgegengesetzte Leiterplattenseite an einem ersten Leiterplattenabschnitt nicht mit elektronischen Komponenten bestückt ist, so ist diese Stelle günstig zur Anordnung einer Leiterbahnfläche, die als Wärmespreizungsfläche wirkt und die aufgenommene Wärme effizient an die darunter befindliche Klebstoffschicht abgeben kann.

Ein einfaches Verfahren zur Herstellung der Elektronikeinheit kann beispielsweise folgende Schritte umfassen:
- Bereitstellen der bereits bestückten Leiterplatte,
- Bereitstellen eines konturierten Gehäusebodens mit erhabenen Gehäuseinnenseitenbereichen und mit einer am Rand des Gehäusebodens umlaufenden Nut,
- Aufbringen von Flüssigklebstoff an den erhabenen Gehäusebodenflächen und an dem Nutengrund,
- Aufdrücken der Leiterplatte zur Verklebung dieser Leiterplatte an den erhabenen Gehäusebodenflächen,
- Bereitstellen eines Gehäusedeckels mit einem zum Eingriff in die Gehäusebodennut geeigneten Vorsprung, und
- Aufdrücken des Gehäusedeckels auf den Gehäuseboden zur Herstellung einer geklebten Nut-und-Vorsprung-Verbindung zwischen Gehäuseboden und Gehäusedeckel sowie zur Kontaktierung von Anschlusspins der Steckverbinderanordnung in Einpresstechnik.

Eine Steckverbindungsanordnung kann z. B. nach dem Bestücken der Leiterplatte mittels Einpresstechnik an der Leiterplatte kontaktiert werden, bevor die Leiterplatte verklebt wird. Alternativ ist es z. B. möglich, die Steckverbindungsanordnung am Gehäusedeckel integriert vorzusehen und zusammen mit dem Gehäusedeckel aufzudrücken.

Die Erfindung wird nachfolgend anhand eines Ausführungsbeispiels mit Bezug auf die beigefügten Zeichnungen näher erläutert. Es stellen dar:
- Fig. 1: eine Explosionsansicht eines Steuergeräts für ein Kraftfahrzeug,
- Fig. 2: eine Schnittansicht des Steuergeräts im montierten Zustand mit einer in einer Längsrichtung verlaufenden Schnittebene, und
- Fig. 3: eine Schnittansicht des Steuergeräts im montierten Zustand mit einer in einer Querrichtung verlaufenden Schnittebene.

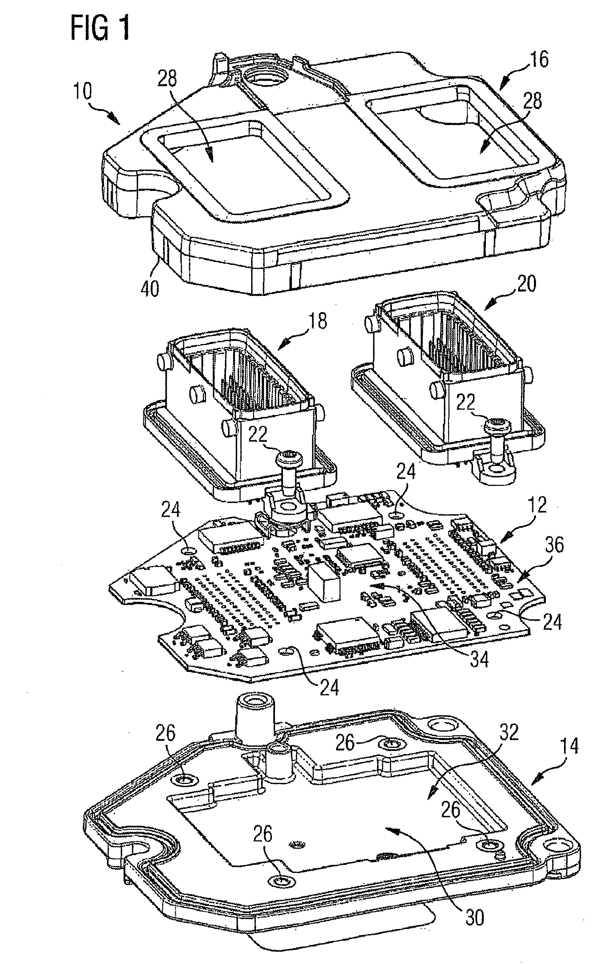

Die Figuren 1 bis 3 zeigen ein insgesamt mit 10 bezeichnetes Steuergerät für ein Kraftfahrzeug. Das Steuergerät 10 ist gebildet aus einer starren, mit elektronischen Komponenten bestückten Leiterplatte 12 (z. B. Epoxid-Substrat mit Kupferleiterbahnen bzw. -flächen) und einem diese Leiterplatte umschließenden Gehäuse, welches zweiteilig umfassend einen Gehäuseboden 14 (Grundplatte) und einen Gehäusedeckel 16 ausgebildet ist. Zum elektrischen Anschluss des Steuergeräts an die Fahrzeugelektronik des betreffenden Kraftfahrzeugs (bzw. an ein Prüfgerät) sind zwei Steckverbinder 18, 20 vorgesehen, die im dargestellten Ausführungsbeispiel zur Kontaktierung mittels Einpresstechnik bei der Steuergerätmontage auf die Oberseite der Leiterplatte 12 aufgesetzt und mit dem Gehäuseboden 14 verschraubt werden. Zu diesem Zweck sind die Steckverbindergehäuse mit Befestigungsschrauben 22 versehen, welche im montierten Zustand Aussparungen 24 der Leiterplatte 12 durchsetzen und in entsprechende Befestigungslöcher 26 des Gehäusebodens 14 eingeschraubt sind. Nach außen hin durchsetzen die Steckverbinder 18, 20 geeignet bemessene Durchtrittsaussparungen 28 des Gehäusedeckels 16.

Der wie der Gehäusedeckel 16 aus einer Aluminiumlegierung gebildete Gehäuseboden 14 besitzt eine konturierte Formgebung derart, dass sich in einem mittleren Bereich des Bodens 14 ein zusammenhängender, etwa rechteckiger, vertiefter Gehäuseinnenseitenabschnitt 30 ergibt, der an dessen Rand umlaufend an einen erhabenen Gehäuseinnenseitenabschnitt 32 angrenzt.

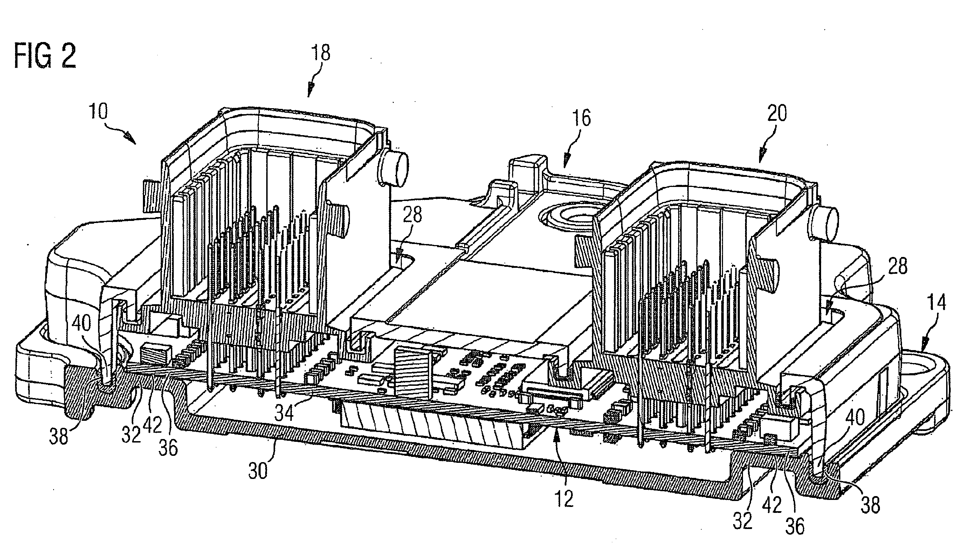

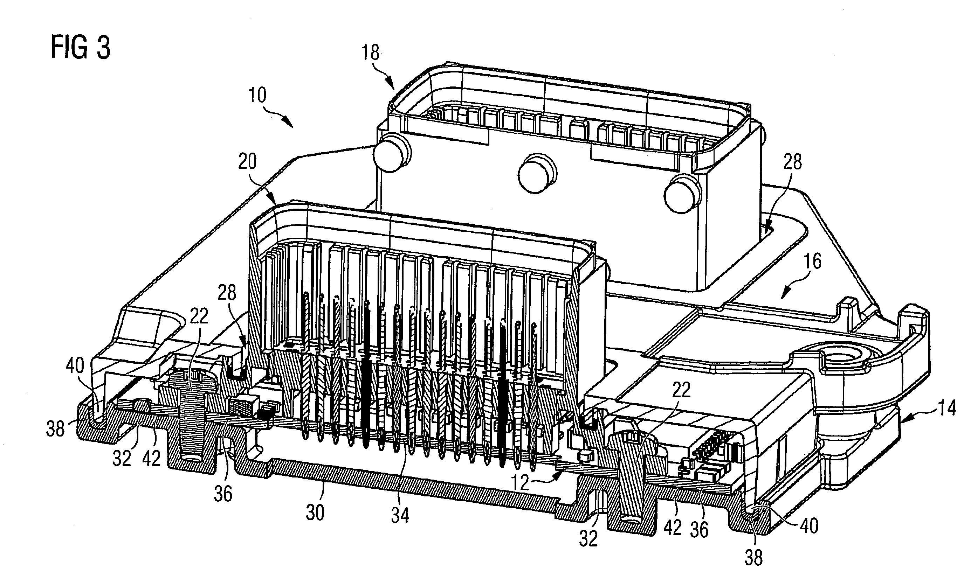

Dieser Anordnung von vertieften und erhabenen Gehäuseabschnitten 30, 32 entsprechend weist die Leiterplatte 12 einen zusammenhängenden mittleren Leiterplattenabschnitt 34 (erster Leiterplattenabschnitt) auf, der im montierten Zustand in einem gewissen Abstand von dem Gehäuseboden angeordnet ist und der zweiseitig mit elektronischen Komponenten bestückt ist, wohingegen die Leiterplatte 12 einen ringförmig geschlossen am Leiterplattenrand verlaufenden äußeren Leiterplattenabschnitt 36 (zweiter Leiterplattenabschnitt) aufweist, dessen Unterseite über eine wärmeleitende Klebstoffschicht 42 (Fig. 2 und 3) unmittelbar mit dem erhabenen Gehäuseinnenseitenabschnitt 32 verbunden ist.

Diese partielle Anbindung der Leiterplatte 12 über die Klebstoffschicht 42 gewährleistet eine zuverlässige mechanische Halterung der Leiterplatte 12 und wirkt darüber hinaus als effizienter Ableitungspfad für Wärme, die im Betrieb des Steuergeräts 10 von den elektronischen Komponenten erzeugt wird. Der Klebstoff besitzt eine Wärmeleitfähigkeit von etwa 2 W/mK. Daher eignet sich das Steuergerät 10 insbesondere für einen motornahen Verbau in einem Kraftfahrzeug, da der beschriebene Aufbau die hinsichtlich mechanischen Belastungen (z. B. Vibrationen) und Temperatur rauen Umgebungsbedingungen gut bewältigen kann.

Bei dem dargestellten Motorsteuergerät 10 kommen eine Anzahl von aktiven Leistungshalbleiterbauelementen zum Einsatz, beispielsweise in einem Schaltungsbereich zur DC/DC-Abwärtswandlung einer Bordspannung für die Versorgung eines Schaltungsteils zur digitalen Signalverarbeitung sowie in einem Schaltungsbereich zur DC/DC-Aufwärtswandlung für die Versorgung eines Schaltungsteils zur Ansteuerung einer Kraftstoffinjektoranordnung der Brennkraftmaschine. Diese elektronischen Leistungsbauteile sind weitgehend auf der Oberseite des äußeren Leiterplattenabschnitts 36 angeordnet, da von diesem Abschnitt weg eine effiziente Wärmeableitung nach unten durch die Klebstoffschicht 42 hindurch zum Gehäuse erfolgen kann.

Die bei dem dargestellten Ausführungsbeispiel verwendeten Steckverbinder 18, 20 besitzen geradlinig nach unten verlaufende Anschlusspins, die sich fertigungstechnisch einfach in entsprechend dimensionierte Kontaktlöcher der Leiterplatte 12 einpressen lassen ("Press-fit-Technik). Ein weiterer Vorteil der Verwendung von solchen ungebogenen Anschlusspins besteht darin, dass sich die Steckverbinder 18, 20 hinsichtlich der Grundfläche des Steuergeräts 10 günstig im Gehäusedeckel 16 integrieren lassen (sei es vor oder nach dem Schließen des Gehäuses) und nicht wie oftmals bei herkömmlichen Steuergeräten in einem Gehäuseseitenwandbereich integriert sind und somit die Grundfläche des Gehäuses unnötig vergrößern. Die Kontaktierung der Anschlusspins im mittleren Leiterplattenabschnitt 34 hat schließlich den Vorteil, dass die von elektronischen Komponenten zu den Anschlusspins führenden Leiterbahnen der Leiterplatte 12 vergleichsweise einfach im Sinne eines weniger komplizierten Schaltungsplattenlayouts angeordnet werden können. Insbesondere können die Leiterbahnen tendenziell kürzer und direkter zwischen einzelnen Komponenten und einzelnen Anschlusspins verlaufen. Im Gegensatz dazu ist bei einer Kontaktierung im Randbereich der Leiterplatte, wie sie oftmals bei herkömmlichen Steuergeräten mit abgewinkelten Steckverbinder-Anschlusspins vorgesehen ist, das Leiterplattenlayout aufwändiger bzw. weniger kompakt hinsichtlich der beanspruchten Leiterplattenfläche. Hinsichtlich der Wärmeableitungseigenschaften des beschriebenen Steuergeräts 10 ist die zentrumsnahe Anordnung der Steckverbinder 18, 20 darüber hinaus auch insofern vorteilhaft, als die eher wärmeableitenden als wärmeerzeugenden Anschlusspins in demjenigen Leiterplattenabschnitt (34) angeordnet sind, der weniger effizient gekühlt wird als der äußere Leiterplattenabschnitt 36, und insofern, als die Anschlusspins keine Leiterplattenfläche im effizient gekühlten äußeren Leiterplattenabschnitt 36 beanspruchen, der zur Bestückung mit stark wärmeerzeugenden Komponenten (z. B. Leistungstransistoren) bevorzugt zu verwenden ist.

Zur Montage des Steuergeräts 10 wird der erhabene Gehäuseinnenseitenabschnitt 32 sowie der Grund einer am Gehäuseboden 14 umlaufenden Nut 38 mit einem Flüssigklebstoff (z. B. auf Silikonbasis) versehen. Sodann wird die bereits bestückte Leiterplatte 12 im Gehäuseboden 14 positioniert und auf die Klebstoffschicht aufgelegt. Anschließend werden die Steckverbinder 18, 20 mit deren Anschlusspins in Einpresstechnik an der Leiterplatte 12 kontaktiert und mittels der Befestigungsschrauben 22 befestigt. Beim dargestellten Ausführungsbeispiel wirkt die Verschraubung der Steckverbinder 18, 20 als zusätzliche (an sich nicht notwendige) Befestigung der Leiterplatte 12 im Gehäuseboden 14. Schließlich wird der Gehäusedeckel 16 von oben derart aufgesetzt, dass ein an dessen Rand umlaufend sich erstreckender Vorsprung 40 mit der Nut 38 in Eingriff gelangt und verklebt wird. Alternativ können die Steckverbinder 18, 20 zunächst auf der Leiterplattenoberseite angebracht werden. Wenn an den Steckverbindern umlaufend eine Nut vorgesehen ist, so kann auch die Verbindung zwischen den Steckverbindern 18,20 und dem Gehäusedeckel 16 vorteilhaft mittels einer Nut-und-Vorsprung-Verklebung realisiert werden.

## Patentansprüche

1. Elektronikeinheit, insbesondere Steuergerät für ein Kraftfahrzeug, umfassend eine mit elektronischen Komponenten bestückte Leiterplatte (12) und ein die Leiterplatte umschließendes Gehäuse (14, 16),
wobei die Leiterplatte (12) wenigstens einen ersten Leiterplattenabschnitt (34) besitzt, der in einem Abstand von dem Gehäuse (14, 16) angeordnet ist und zweiseitig mit elektronischen Komponenten bestückt ist, und wenigstens einen zweiten Leiterplattenabschnitt(36) besitzt, der über eine wärmeleitende Klebstoffschicht (42) mit dem Gehäuse verbunden ist,
wobei das Gehäuse (14, 16) einen Gehäuseboden (14) und einen damit verbundenen Gehäusedeckel (16) umfasst und
wobei der Gehäuseboden (14) im Querschnitt betrachtet wenigstens eine Einbuchtung zur Bereitstellung von Gehäuseinnenseitenabschnitten (32) aufweist, die zur Verbindung mit dem wenigstens einen zweiten Leiterplattenabschnitt (36) über die Klebstoffschicht (42) verwendet sind,
**dadurch gekennzeichnet, dass**
- der erste Leiterplattenabschnitt (34) in einem mittleren Bereich der Leiterplatte (12) angeordnet ist,
- der zweite Leiterplattenabschnitt (36) an einem Rand der Leiterplatte (12) angeordnet ist, und
- die Verbindung zwischen Gehäuseboden (14) und Gehäuse-deckel (16) als eine geklebte Nut-und-Vorsprung-Verbindung (38, 40) ausgebildet ist, bei welcher ein am Gehäusedeckel (16) ringförmig geschlossen am Rand umlaufender Vorsprung (40) in eine am Gehäuseboden (14) korrespondierend angeordnete Nut (38) eingreift und damit verklebt ist.

2. Elektronikeinheit nach Anspruch 1, wobei für die geklebte Nut-und-Vorsprung-Verbindung (38, 40) der gleiche Klebstoff wie für die Verbindung zwischen der Leiterplatte (12) und dem Gehäuse (14, 16) verwendet ist.

3. Elektronikeinheit nach Anspruch 1 oder 2, wobei in dem Gehäusedeckel (16) wenigstens ein Steckverbinder (18, 20) zum elektrischen Anschluss der Elektronikeinheit integriert ist.

4. Elektronikeinheit nach Anspruch 3, wobei Anschlusspins des Steckverbinders (18, 20) geradlinig zu der Leiterplatte (12) verlaufen und unmittelbar an dieser Leiterplatte kontaktiert sind.

5. Elektronikeinheit nach Anspruch 4, wobei die Kontaktierung der Anschlusspins als Einpresskontaktierung vorgesehen ist.

6. Elektronikeinheit nach einem der vorangehenden Ansprüche, wobei wenigstens einer der zweiten Leiterplattenabschnitte (36) entlang eines Großteils eines Leiterplattenrands verläuft, insbesondere ringförmig geschlossen entlang eines Leiterplattenrands verläuft.

7. Elektronikeinheit nach einem der vorangehenden Ansprüche, wobei wenigstens einer der zweiten Leiterplattenabschnitte (36) auf der der Klebstoffschicht (42) entgegengesetzten Leiterplattenseite mit elektronischen Komponenten bestückt ist.

8. Verfahren zur Herstellung einer Elektronikeinheit (10), umfassend folgende Schritte:
a) Bereitstellen einer Leiterplatte (12) mit wenigstens einem ersten Leiterplattenabschnitt (34), der in einem mittleren Bereich der Leiterplatte (12) angeordnet ist und zweiseitig mit elektronischen Komponenten bestückt ist, und mit wenigstens einem zweiten Leiterplattenabschnitt (36), der an einem Rand der Leiterplatte (12) angeordnet ist und auf einer Seite nicht mit elektronischen Komponenten bestückt ist,
b) Bereitstellen eines konturierten Gehäusebodens (14) mit korrespondierend zu dem wenigstens einen zweiten Leiterplattenabschnitt (36) angeordneten, erhabenen Gehäuseinnenseitenabschnitten (32) und mit einer am Rand des Gehäusebodens (14) ringförmig geschlossenen umlaufenden Nut (38),
c) Aufbringen von wärmeleitendem Klebstoff an den erhabenen Gehäuseinnenseitenabschnitten (32),
d) Aufbringen von Klebstoff an dem Grund der umlaufenden Nut (38),
e) Aufdrücken der Leiterplatte (12) zur Verklebung dieser Leiterplatte an den erhabenen Gehäuseinnenseitenabschnitten (32),
f) Bereitstellen eines Gehäusedeckels (16) mit einem zum ringförmig geschlossen umlaufenden Eingriff in die Nut (38) des Gehäusebodens (14) geeigneten Vorsprung (40) und Aufdrücken des Gehäusedeckels (16) auf den Gehäuseboden (14) zur Herstellung einer geklebten Nut (38)-und-Vorsprung (40)-Verbindung zwischen Gehäuseboden (14) und Gehäusedeckel (16).

9. Verfahren nach Anspruch 8, wobei in den Schritten c) und d) der gleiche Klebstoff verwendet wird.

## Claims

1. Electronic unit, in particular control device for a motor vehicle, comprising a printed circuit board (12) which is populated with electronic components and a housing (14, 16) that encloses the printed circuit board,
wherein the printed circuit board (12) has at least one first printed circuit board section (34) which is arranged at a distance from the housing (14, 16) and is populated on both sides with electronic components, and at least one second printed circuit board section (36) which is connected to the housing via a heat-conducting adhesive layer (42),
wherein the housing (14, 16) comprises a housing floor (14) and a housing cover (16) which is connected thereto, and wherein the housing floor (14), when viewed in cross-section, has at least one indentation for providing housing internal sections (32) that are used for connecting to the at least one second printed circuit board section (36) via the adhesive layer (42),
**characterised in that**
- the first printed circuit board section (34) is arranged in a central area of the printed circuit board (12)
- the second printed circuit board section (36) is arranged at an edge of the printed circuit board (12)
- the connection between housing floor (14) and housing cover (16) is embodied in the form of a glued groove-and-projection connection (38, 40) in which an annularly continuous projection (40) running around the edge of the housing cover (16) engages in a correspondingly arranged groove (38) in the housing floor (14) and is glued thereto.

2. Electronic unit according to claim 1, wherein the same adhesive is used for the glued groove-and-projection connection (38, 40) as is used for the connection between the printed circuit board (12) and the housing (14, 16).

3. Electronic unit according to claim 1 or 2, wherein at least one plug connector (18, 20) for the electrical connection of the electronic unit is integrated in the housing cover (16).

4. Electronic unit according to claim 3, wherein terminal pins of the plug connector (18, 20) run in a straight line to the printed circuit board (12) and are contacted directly to said printed circuit board.

5. Electronic unit according to claim 4, wherein the contacting of the terminal pins is provided in the form of press-fit contacting.

6. Electronic unit according to one of the preceding claims, wherein at least one of the second printed circuit board sections (36) runs along a large part of a printed circuit board edge, in particular in an annularly continuous manner along a printed circuit board edge.

7. Electronic unit according to one of the preceding claims, wherein at least one of the second printed circuit board sections (36) is populated with electronic components on the printed circuit board side which is opposite to the adhesive layer (42).

8. Method for manufacturing an electronic unit (10), comprising the following steps:
a) providing a printed circuit board (12) having at least one first printed circuit board section (34) which is arranged in a central area of the printed circuit board (12) and is populated on both sides with electronic components, and having at least one second printed circuit board section (36) which is arranged at an edge of the printed circuit board (12) and is not populated with electronic components on one side,
b) providing a contoured housing floor (14) having raised housing internal sections (32) that are arranged corresponding to the at least one second printed circuit board section (36) and having a groove (38) which runs in an annularly continuous manner around the edge of the housing floor (14),
c) depositing heat-conducting adhesive on the raised housing internal sections (32),
d) depositing adhesive on the base of the circumferential groove (38),
e) pressing on the printed circuit board (12) in order to bond this printed circuit board onto the raised housing internal sections (32),
f) providing a housing cover (16) having a projection (40) which is suitable for annularly continuous circumferential engagement in the groove (38) of the housing floor (14), and pressing the housing cover (16) onto the housing floor (14) in order to create a glued groove (38)-and-projection (40) connection between housing floor (14) and housing cover (16).

9. Method according to claim 8, wherein the same adhesive is used in steps c) and d).

## Revendications

1. Unité électronique, notamment appareil de commande pour un véhicule automobile, comprenant une carte imprimée (12) équipée de composants électroniques et un boîtier (14, 16) renfermant la carte imprimée,
la carte imprimée (12) possédant au moins un premier segment de carte imprimée (34) qui est disposé à une distance donnée du boîtier (14, 16) et qui est équipé, sur les deux faces, de composants électroniques, et au moins un deuxième segment de carte imprimée (36) qui est relié au boîtier par l'intermédiaire d'une couche de colle (42) conductrice de chaleur,
le boîtier (14, 16) comprenant un fond de boîtier (14) et un couvercle de boîtier (16) relié à ce dernier et le fond de boîtier (14) présentant, en coupe transversale, au moins un creux destiné à fournir des segments de face intérieure de boîtier (32) qui sont utilisés pour l'assemblage avec le deuxième segment de carte imprimée (36) - au moins au nombre de un - par l'intermédiaire de la couche de colle (42),
**caractérisée en ce que**
- le premier segment de carte imprimée (34) est disposé dans une zone centrale de la carte imprimée (12),
- le deuxième segment de carte imprimée (36) est disposé à une périphérie de la carte imprimée (12), et
- l'assemblage entre le fond de boîtier (14) et le couvercle de boîtier (16) est réalisé sous la forme d'un assemblage collé à rainure et saillie (38, 40), dans lequel une saillie (40) sous la forme d'un anneau fermé s'étendant tout le long de la périphérie vient en prise dans une rainure correspondante (38) et y est fixée par la colle.

2. Unité électronique selon la revendication 1, la colle utilisée pour l'assemblage collé à rainure et saillie (38, 40) étant la même que celle utilisée pour l'assemblage entre la carte imprimée (12) et le boîtier (14, 16).

3. Unité électronique selon la revendication 1 ou 2, au moins un connecteur enfichable (18, 20) étant intégré dans le couvercle de boîtier (16) en vue de la connexion électrique de l'unité électronique.

4. Unité électronique selon la revendication 3, des broches de raccordement du connecteur enfichable (18, 20) s'étendant de manière rectiligne à la carte imprimée (12) et leur mise en contact étant réalisée directement au niveau de ladite carte imprimée.

5. Unité électronique selon la revendication 4, la mise en contact des broches de raccordement étant prévue sous forme de mise en contact par pression.

6. Unité électronique selon l'une des revendications précédentes, au moins l'un des deuxièmes segments de carte imprimée (36) s'étendant sur une grande partie d'une périphérie de la carte imprimée, notamment sous la forme d'un d' anneau fermé s'étendant le long d'une périphérie de la carte imprimée.

7. Unité électronique selon l'une des revendications précédentes,
au moins un des deuxièmes segments de carte imprimée (36) étant équipé, sur la face de carte imprimée située à l'opposé de la couche de colle (42), de composants électroniques.

8. Procédé permettant de fabriquer une unité électronique (10) et comprenant les étapes suivantes :
a) la fourniture d'une carte imprimée (12) avec au moins un premier segment de carte imprimée (34) qui est disposé dans une zone centrale de la carte imprimée (12) et qui est équipé, sur les deux faces, de composants électroniques, et avec au moins un deuxième segment de carte imprimée (36) qui est disposé à une périphérie de la carte imprimée (12) et qui, sur une face, n'est pas équipé de composants électroniques,
b) la fourniture d'un fond de boîtier à contour (14) avec des segments de face intérieure de boîtier saillants (32), disposés de manière à correspondre au deuxième segment de carte imprimée (36) - au moins au nombre de un et avec une rainure (38) en forme d'anneau fermé s'étendant tout le long de la circonférence du fond de boîtier (14),
c) l'application de colle conductrice de chaleur au niveau des segments de face intérieure de boîtier saillants (32),
d) l'application de colle au fond de la rainure circonférencielle (38),
e) l'application d'une pression sur la carte imprimée (12) afin de coller celle-ci au niveau des segments de face intérieure de boîtier saillants (32),
f) la fourniture d'un couvercle de boîtier (16) présentant une saillie (40) sous la forme d'un anneau fermé s'étendant de manière circonférencielle, propre à venir en prise dans la rainure (38) du fond de boîtier (14) et l'application du couvercle de boîtier (16) sur le fond de boîtier (14) en exerçant une pression afin de réaliser un assemblage collé à rainure (38) et saillie (40) entre le fond de boîtier (14) et le couvercle de boîtier (16).

9. Procédé selon la revendication 8, la colle utilisée dans les étapes c) et d) étant la même.
